# EUROPEAN PATENT SPECIFICATION

(11) **EP 2 484 798 B1**
(45) Date of publication and mention of the grant of the patent: **12.12.2018**
(21) Application number: 12153675.9
(22) Date of filing: 02.02.2012
(51) Int. Cl.: C23C 14/32, H01J 37/34

(54) **Cylindrical post cathode and physical vapor deposition system**
Zylindrische Kathode und physikalisches Dampfabscheidungssystem
Post-cathode cylindrique et système de dépôt de vapeur physique

(30) Priority: 02.02.2011 US 201113019323
(43) Date of publication of application: 08.08.2012
(73) Proprietor: United Technologies Corporation, Farmington, CT 06032 (US)
(72) Inventor: Beers, Russell A., Manchester, CT Connecticut 06040 (US)
(74) Representative: Dehns

(56) References cited:
- EP-A1- 0 284 145
- EP-A1- 1 997 932
- EP-A2- 1 650 324
- WO-A1-02/50865
- US-A1- 2005 189 218
- US-A1- 2008 138 529

## Description

### BACKGROUND

The present disclosure relates to a steered arc physical vapor deposition system, and more particularly to a cylindrical post cathode for a steered arc physical vapor deposition system.

Physical vapor deposition (PVD) systems are utilized in cathodic arc coating to vaporize a material and deposit that material on a piece, thereby coating the piece with a thin layer of the material. PVD systems use a cathode/anode arrangement where the cathode includes an evaporation surface made from the coating material. The cathode and the anode of the PVD system are contained within a vacuum chamber. A power source is connected to the cathode and the anode with the positive connection of the power source connected to the anode and the negative connection of the power source connected to the cathode. By connecting the positive power connection to the anode and the negative power connection to the cathode, a charge disparity between the anode and the cathode is generated.

The charge disparity causes an electrical arc to jump between the cathode and the anode. In standard PVD systems, the arc location is random over the surface of the cathode. The arcing causes the evaporation surface of the cathode to vaporize at the point where the arc occurred. The vaporized cathode material then coats the piece contained in the vacuum chamber.

In order to control the density and distribution of the coating, steered arc systems control the location of the arc on the cathode's surface by manipulating magnetic fields.

US 2008/0138529 discloses a cylindrical post cathode according to the preamble of claim 1.

EP 1997932 discloses a method of arc ion plating and a target for use therein.

US 2005/0189218 discloses a cathodic arc coating apparatus.

EP 0284145 discloses a cathode arc discharge evaporating device.

WO 02/50865 discloses an apparatus for evaporation of materials for coating of objects.

### SUMMARY

In accordance with a first aspect of the present invention there is provided a cylindrical post cathode for a steered arc physical vapor deposition system, as set forth in claim 1.

In accordance with a second aspect of the present invention, there is provided a steered arc physical vapor deposition system as set forth in claim 2.

### BRIEF DESCRIPTION OF THE DRAWINGS

The disclosure can be further understood by reference to the following detailed description when considered in connection with the accompanying drawings wherein:
Figure 1 schematically illustrates an example steered arc physical vapor deposition (PVD) system falling outside the scope of the invention and including a cylindrical post cathode.
Figure 2 schematically illustrates an example steered arc PVD system falling outside the scope of the invention and incorporating actuation for magnet control.
Figure 3 schematically illustrates an example steered arc PVD system incorporating fluid actuation for magnet control in accordance with the invention.

### DETAILED DESCRIPTION

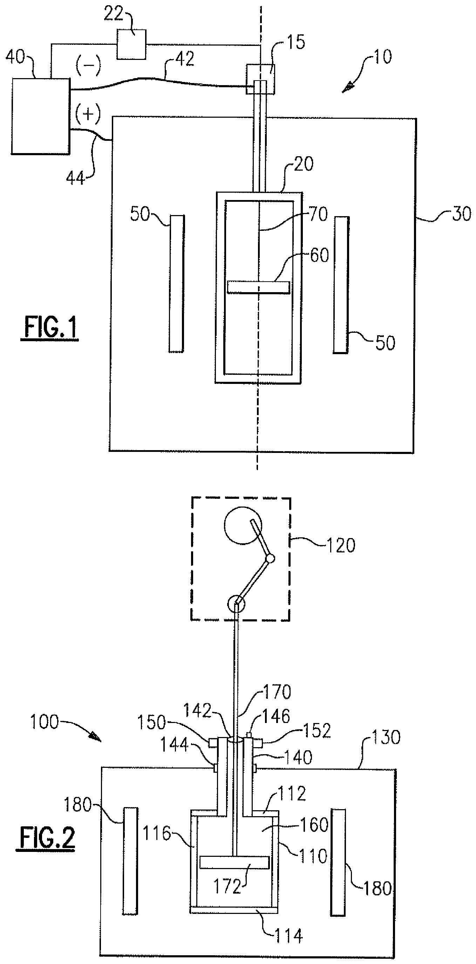

Figure 1 illustrates an example steered arc physical vaporization deposition (PVD) system 10 falling outside the scope of the invention and that includes a cylindrical post cathode 20. The cylindrical post cathode 20 is a hollow cylindrical tube with a magnet 60 suspended within the tube via a shaft 70. A vacuum chamber 30 surrounds the post cathode 20, with the inner surfaces of the vacuum chamber 30 functioning as the anode. Alternately, a separate anode structure can be located within the vacuum chamber 30. A power source 40 provides a negative charge 42 to the cathode 20 and a positive charge 44 to the anode 30 during operation of the PVD system 10. A controller 22 directs operation of an actuation device 15 and application of electric power to the cathode 20 and the anode.

When the PVD system 10 is operating, the magnetic field generated by the magnet 60 forces the arc to occur at an intersection of the magnetic field and the surface of the cathode 20, thereby influencing where a vaporized coating will settle on a part 50. The magnet 60 is suspended within the post cathode 20 on the shaft 70. The shaft 70 moves the magnet 60 along an axis defined by the shaft 70, the magnet 60, and the post cathode 20. Shifting the position of the magnet 60, provides for positioning of the arc for controlling vapor deposition. The shaft 70 extends out of the vacuum chamber 30 and is connected to an actuation device 15. While the magnet 60 is described herein as a single magnet 60, it is understood that a magnet assembly, or some combination of permanent magnets and electromagnets, could also be used with minimal modification to the disclosure.

Figure 2 illustrates an example PVD system 100 falling outside the scope of the invention and including a magnet shaft 170 actuated by a cam system 120, for controlling magnet 172 position. A cylindrical post cathode 110 is suspended in the vacuum chamber 130 via a shaft 140. The shaft 140 includes a center passageway 142 through which the magnet shaft 170 passes. The magnet shaft 170 is attached to magnet 172, and maintains the magnet 172 in a desired position or moves the magnet 172 to a new position. The shaft 140 includes a seal 144 where it enters the vacuum chamber 130 for maintaining the vacuum. An electrical charge can be provided to the cathode 110 through an electrical connector 146 on the cooling shaft 140. The cooling shaft 140 further includes fluid passageways 150, 152, which provide for the inlet and outlet of a cooling fluid 160. The cooling fluid 160 cools the post cathode 110, and can be any known cooling fluid.

The cylindrical post cathode 110 has a top cap portion 112, a bottom cap portion 114 and a side wall portion 116. The side wall portion 116 is an evaporation source material that is evaporated during a cathodic arc. The vapor is deposited on an adjacent part 180 to provide a thin coating of the source material on the workpiece.

Alternate PVD systems using cylindrical post cathodes 110 may not require a cooling fluid. These PVD systems do not include the cooling fluid inlet and outlet 150, 152, with all other features being substantially the same as the above described example. Another example PVD system replaces the camshaft actuation system 120 with a linear actuator, to provide desired precision and accuracy over movement and positioning of the magnet 172.

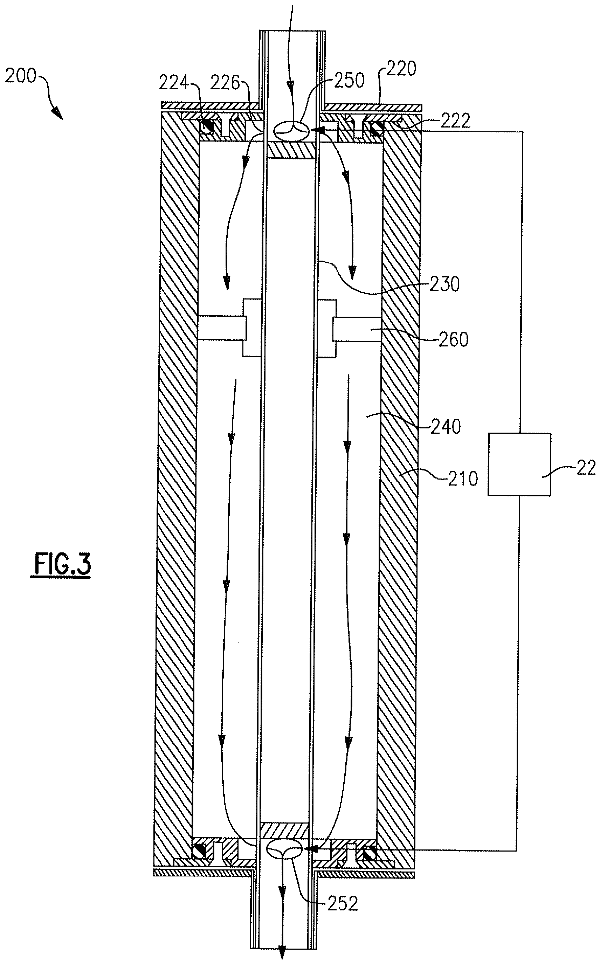

In accordance with the invention, a fluid actuating system is implemented as an alternate to the above described mechanical actuation systems for adjusting the location of the magnet 70. Referring to Figure 3, an example fluid actuated magnet cylindrical post cathode 200 is disclosed. The fluid actuated magnet cylindrical post cathode 200 is a cylindrical tube. The side walls 210 of the tube are constructed of an evaporation source material. Each end of the tube is capped with a shield assembly 220. The shield assembly 220 covers and protects an electrical contact 222 that connects the cylindrical post cathode 200 to a power source 40 (illustrated in Figure 1). The contact 222 is sealed to the side walls 210 via a standard o-ring 224. The contact 222 further includes an opening 226 that allows fluid from a cooling shaft 230 to enter the hollow center portion 240 of the cylindrical post cathode 200. Fluid flow into the center portion 240 of the cathode 200 is controlled via a top valve 250 and a bottom valve 252.

The magnet 260 is slidably mounted on the cooling shaft 230. The axial position of the magnet 260 is adjusted by altering the pressures of the cooling fluid 240 above and below the magnet 260. By increasing the pressure below the magnet 260, relative to the pressure above the magnet 260, the magnet 260 moves axially up along the cooling shaft 230. Likewise, decreasing the pressure below the magnet 260, relative to the pressure above the magnet 260, causes the magnet 260 to be moved axially down along the cooling shaft 230. In this way, a controller 22 (Figure 1) can manipulate cooling fluid valves 250, 252 and thereby control the location of the magnet and the cathodic arc. Manipulation of the valves 250, 252 to affect the fluid pressure operates according to known principles.

Returning to the example of Figure 1, any of the above described magnet actuation methods can be incorporated into the PVD system 10. Figure 1 illustrates two parts 50 being coated. Alternately, the cylindrical post cathode 110 allows for coating the inside of a part 50 by sliding the part 50 onto the cathode 20 as a sleeve. This provides for a more consistent coverage of the interior surfaces of the part 50 than previous systems.

Although an example embodiment has been disclosed, a worker of ordinary skill in this art would recognize that certain modifications would come within the scope of the claims. For that reason, the following claims should be studied to determine their true scope and content.

## Claims

1. A cylindrical post cathode (200) for a steered arc physical vapor deposition system (10, 110) comprising:
a cylindrical tube;
a magnet (260) disposed within said cylindrical tube, wherein said magnet (260) is movable along an axis defined by said tube; and
wherein a side wall (210) of said cylindrical tube comprises an evaporation source material;
wherein said axial position of said magnet (260) controls a position of a cathodic arc, wherein
said magnet (260) is mounted to a shaft (230), and said shaft (230) is at least partially disposed within said cylindrical tube, wherein said shaft (230) is fixed within said cylindrical tube and includes at least one passage (226) for distributing cooling fluid to said cathode (200) such that said magnet (260) is suspendable in cooling fluid;
**characterised in that** each end of said cylindrical post cathode (20; 110; 200) is capped with a shield assembly (220), wherein said shield assembly (220) covers and protects an electrical contact (222) that is adapted to connect said cylindrical post cathode (200) to a power source (40) and **in that** said magnet (260) is slidably mounted to an outer surface of said shaft (230), the position of said magnet (260) on the shaft (230) being dependent on a fluid pressure above said magnet (260) and a fluid pressure below said magnet (260).

2. A steered arc physical vapor deposition system (10, 100) comprising:
a vacuum chamber (30; 130);
a cylindrical post cathode (200) according to claim 1 inside said vacuum chamber (30; 130); and
a power source (40) configured to provide a first charge (42) to said cylindrical post cathode (200) and a second charge (44) to an anode, wherein said first charge (42) and said second charge (44) are opposite charges.

3. The steered arc physical vapor deposition system (10; 100) of claim 2, wherein said anode comprises an interior surface of said vacuum chamber (30; 130).

4. The steered arc physical vapor deposition system (10; 100) of claim 2, wherein said anode comprises at least one anode structure positioned inside said vacuum chamber (30; 130).

## Patentansprüche

1. Zylindrische Kathode (200) für ein physikalisches Dampfabscheidungssystem mittels gesteuerten Bogens (10; 110), die Folgendes umfasst:
ein zylindrisches Rohr;
einen Magnet (260), der innerhalb des zylindrischen Rohrs angeordnet ist, wobei der Magnet (260) entlang einer Achse beweglich ist, die durch das Rohr definiert ist; und
wobei eine Seitenwand (210) des zylindrischen Rohrs ein Verdampfungs-Ausgangsmaterial umfasst;
wobei die axiale Position des Magneten (260) eine Position eines kathodischen Bogens kontrolliert, wobei der Magnet (260) an eine Stange (230) angebracht ist und die Stange (230) zumindest teilweise innerhalb des zylindrischen Rohrs angeordnet ist, wobei die Stange (230) innerhalb des zylindrischen Rohrs befestigt ist und mindestens einen Durchlass (226) beinhaltet zur Verteilung von Kühlflüssigkeit zu der Kathode (200), sodass der Magnet (260) in Kühlflüssigkeit suspendierbar ist;
**dadurch gekennzeichnet, dass** jedes Ende der zylindrischen Kathode (20; 110; 200) durch eine Abschirmbaueinheit (220) verschlossen ist, wobei die Abschirmbaueinheit (220) einen elektrischen Kontakt (222) bedeckt und schützt, der ausgelegt ist, um die zylindrische Kathode (200) mit einer Stromquelle (40) zu verbinden, und dass der Magnet (260) verschiebbar an einer äußeren Fläche der Stange (230) angebracht ist, wobei die Position des Magneten (260) auf der Stange (230) abhängig ist von einem Flüssigkeitsdruck über dem Magneten (260) und einem Flüssigkeitsdruck unter dem Magneten (260).

2. Physikalisches Dampfabscheidungssystem mittels gesteuerten Bogens (10; 100), das Folgendes umfasst:
eine Vakuumkammer (30; 130);
eine zylindrische Kathode (200) nach Anspruch 1 innerhalb der Vakuumkammer (30; 130); und
eine Stromquelle (40), die konfiguriert ist, um eine erste Ladung (42) für die zylindrische Kathode (200) und eine zweite Ladung (44) für eine Anode bereitzustellen, wobei die erste Ladung (42) und die zweite Ladung (44) entgegengesetzte Ladungen sind.

3. Physikalisches Dampfabscheidungssystem mittels gesteuerten Bogens (10; 100) nach Anspruch 2, wobei die Anode eine innere Fläche der Vakuumkammer (30; 130) umfasst.

4. Physikalisches Dampfabscheidungssystem mittels gesteuerten Bogens (10; 100) nach Anspruch 2, wobei die Anode mindestens eine Anodenstruktur umfasst, die innerhalb der Vakuumkammer (30; 130) positioniert ist.

## Revendications

1. Post-cathode cylindrique (200) pour un système de dépôt de vapeur physique à arc orienté (10, 110) comprenant :
un tube cylindrique ;
un aimant (260) disposé dans ledit tube cylindrique, dans lequel ledit aimant (260) est mobile autour d'un axe défini par ledit tube ; et
dans lequel une paroi latérale (210) dudit tube cylindrique comprend un matériau de source d'évaporation ;
dans lequel ladite position axiale dudit aimant (260) commande une position d'un arc cathodique, dans lequel ledit aimant (260) est monté sur un arbre (230), et ledit arbre (230) est au moins partiellement disposé dans ledit tube cylindrique, dans lequel ledit arbre (230) est fixé dans ledit tube cylindrique et comprend au moins un passage (226) pour la distribution de liquide de refroidissement à ladite cathode (200) de sorte que ledit aimant (260) peut être suspendu dans du liquide de refroidissement ;
**caractérisé en ce que** chaque extrémité de ladite post-cathode cylindrique (20 ; 110 ; 200) est couverte par un ensemble de bouclier (220), dans lequel ledit ensemble de bouclier (220) couvre et protège un contact électrique (222) qui est adapté pour connecter ladite post-cathode cylindrique (200) à une source d'alimentation (40) et **en ce que** ledit aimant (260) est monté de façon coulissante sur une surface externe dudit arbre (230), la position dudit aimant (260) sur l'arbre (230) dépendant d'une pression de liquide au-dessus dudit aimant (260) et une pression de liquide en dessous dudit aimant (260).

2. Système de dépôt de vapeur physique à arc orienté (10, 100) comprenant :
une chambre à vide (30 ; 130) ;
une post-cathode cylindrique (200) selon la revendication 1 à l'intérieur de ladite chambre à vide (30 ; 130) ; et
une source d'alimentation (40) configurée pour fournir une première charge (42) à ladite post-cathode cylindrique (200) et une seconde charge (44) à une anode, dans lequel ladite première charge (42) et ladite seconde charge (44) sont des charges opposées.

3. Système de dépôt de vapeur physique à arc orienté (10 ; 100) selon la revendication 2, dans lequel ladite anode comprend une surface intérieure de ladite chambre à vide (30 ; 130).

4. Système de dépôt de vapeur physique à arc orienté (10 ; 100) selon la revendication 2, dans lequel ladite anode comprend au moins une structure d'anode positionnée à l'intérieur de ladite chambre à vide (30 ; 130).
